# EUROPEAN PATENT SPECIFICATION

(11) **EP 4 040 471 B1**
(45) Date of publication and mention of the grant of the patent: **06.08.2025**
(21) Application number: 21155784.8
(22) Date of filing: 08.02.2021
(51) Int. Cl.: H01L 21/48, H01L 25/07, H01L 23/544, H01L 23/495, H01L 23/473, H01L 23/40, H01L 25/18

(54) **POWER SEMICONDUCTOR MODULE, POWER SEMICONDUCTOR DEVICE AND METHOD FOR PRODUCING A POWER SEMICONDUCTOR DEVICE**
LEISTUNGSHALBLEITERMODUL, LEISTUNGSHALBLEITERBAUELEMENT UND VERFAHREN ZUR HERSTELLUNG EINES LEISTUNGSHALBLEITERBAUELEMENTS
MODULE SEMI-CONDUCTEUR DE PUISSANCE, DISPOSITIF SEMI-CONDUCTEUR DE PUISSANCE ET PROCÉDÉ DE FABRICATION D'UN DISPOSITIF SEMI-CONDUCTEUR DE PUISSANCE

(43) Date of publication of application: 10.08.2022
(73) Proprietor: Hitachi Energy Ltd, 8050 Zürich (CH)
(72) Inventor: TRUESSEL, Dominik, 5620 Bremgarten (CH); BEYER, Harald, 5600 Lenzburg (CH); MALEKI, Milad, 5417 Untersiggenthal (CH)
(74) Representative: Epping - Hermann - Fischer

(56) References cited:
- EP-A1- 2 395 647
- WO-A1-2013/140704
- DE-A1- 102019 202 903
- JP-A- 2001 168 278
- JP-A- 2006 086 438
- JP-A- 2015 128 138
- US-A1- 2017 110 341

## Description

Document JP 2001 168278 A describes a power semiconductor module and a power conversion device, document JP 2015 128138 A describes a semiconductor device, document US 2017/110341 A1 describes a semiconductor device manufacturing method and document EP 2 395 647 A1 describes a power converter.

The present disclosure relates to a power semiconductor module, a power semiconductor device and a method for producing a power semiconductor device.

Exemplarily, power semiconductor modules provided with base plates having pin fins are mounted on a cooler for direct liquid cooling. For example, a correct positioning of the power semiconductor modules is needed to achieve a tight mechanical connection between the cooler and the power semiconductor module without any leakage of a cooling medium during operation. Furthermore, a correct positioning of the pin fins within the cooling cavity of the cooler provides, for example, an optimum cooling efficiency.

When mounting several power semiconductor modules on the cooler, not only the positioning of the power semiconductor modules on the cooler itself, but also an alignment of the power semiconductor modules relative to one another is important. Only a correct alignment facilitates a proper fitting of corresponding control terminals of the power semiconductor modules to a common control board.

Embodiments of the disclosure address in whole or in part the above shortcomings by a power semiconductor module which has an improved reliability, a power semiconductor device having such a power semiconductor module and a method for producing such a power semiconductor device.

The exemplary embodiment of the disclosure addresses the above shortcomings by the subject-matter of the independent claims. Further exemplary embodiments are evident from the dependent claims and the following description.

A first aspect relates to a power semiconductor device. The term "power" here and in the following, for example, refers to power semiconductor modules, semiconductor chips and power semiconductor devices adapted for processing voltages and currents of more of 100 V, e.g. more than 5000 V, and/or more than 10 A, e.g. more than 1000 A. For example, the power semiconductor module is used in automotive applications, such as electric vehicles, hybrid vehicles, motorbikes, buses, trucks, off-road construction vehicles and charging stations.

The power semiconductor module has, for example, a main plane of extension. Lateral directions are aligned parallel to the main plane of extension and a vertical direction is aligned perpendicular to the main plane of extension.

According to the embodiment of the first aspect, the power semiconductor module comprises at least one semiconductor chip being connected to a cooling structure.

For example, the power semiconductor module comprises a base plate comprising a cooling structure at a first main side.

Alternatively, the semiconductor module is a base plate-less power semiconductor module.

For example, the cooling structure comprises a plurality of pin fins. Each pin fin is exemplarily formed from a pillar, wherein a tip of each pin fin extends in vertical direction facing away from the first main side. For example, all of the pin fins have a common direction of extension being parallel to the vertical direction. For example, the pin fins increase an area of a bottom surface of the base plate at the first main side.

For example, the base plate comprises or consists of a metal, such as Cu. The pin fins are formed, for example, from the same material as the base plate, such as Cu. For example, the cooling structure and the base plate are formed integrally with one another.

The semiconductor chip comprises, for example, a substrate or a lead frame. The substrate or the lead frame is, e.g., mounted on the base plate. The semiconductor chip is, for example, directly arranged on the substrate. Exemplarily, the at least one semiconductor chip is arranged on the base plate at a second main side opposite the first main side. The semiconductor chip is based, for example, on silicon or a wide bandgap material, exemplarily silicon carbide.

The semiconductor chip, for example, is formed of at least one of a diode and a switch. The semiconductor chip is, exemplarily, a transistor, a varistor, an insulated gate bipolar transistor, IGBT for short, or a metal oxide semiconductor field-effect transistor, MOSFET for short, or a metal insulator semiconductor field-effect transistor, MISFET for short.

The power semiconductor module exemplarily comprises at least two semiconductor chips. The two semiconductor chips are spaced apart from one another in lateral directions. For example, one of the at least two semiconductor chips is formed as a switch and the other of the at least two semiconductor chips is formed as a diode. In this case, the switch and the diode are connected antiparallel to one another. The at least two semiconductor chips being connected antiparallel to one another form, for example, a half bridge. For example, the power semiconductor module comprises one or more half bridges.

According to at least one embodiment, the power semiconductor module comprises at least two power terminals being in electrical contact to at least one semiconductor chip. For example, the power terminals are configured for external contacting of the power semiconductor module, i.e. the semiconductor chip. The power terminals exemplary extend in lateral directions at least in regions. The power terminals comprise or consist, for example, of a metal, exemplarily Cu.

For example, the power terminals show traces of an alignment process at the first side. The traces of an alignment process are, e.g. scratch marks.

According to the embodiment, the power semiconductor module comprises a housing for the power semiconductor chip and the at least two power terminals. The housing is formed, for example, by any element being a package for the power semiconductor chip, e.g. comprising an encapsulation material such as a mold compound, a gel or a resin, e.g. a potting resin.

For example, the housing comprises a mold compound arranged on the power semiconductor chip, the at least two power terminals and the base plate at the second main side. For example, the mold compound is in direct contact to the power semiconductor module, the power terminals and the base plate. The mold compound comprises or consists of an epoxy mold compound, exemplarily an epoxy resin.

For example, the power semiconductor chip is encapsulated completely by the mold compound and the base plate. "Encapsulated" means here and in the following that the semiconductor chip is three-dimensionally encapsulated.

Further, each of the power terminals is embedded at least in regions within the housing, e.g. the mold compound. "Embedded" means here and the following that an outer surface of each power terminal is at least in regions close to the semiconductor chip covered by the housing, e.g. the mold compound.

According to at least one embodiment of the power semiconductor module, each of the at least two power terminals has a protruding part protruding from the housing in lateral directions. This is to say that each power terminal exemplary protrudes beyond the housing in lateral directions. The protruding parts are, for example, free of the housing. Exemplarily, the protruding parts are freely accessible in order to be externally contactable.

According to at least one embodiment of the power semiconductor module, at least two protruding parts are provided with a first alignment hole. For example, each of the first alignment holes completely penetrates the power terminals in vertical direction.

For example, each of the first alignment holes comprises at least one side surface. At least one of the side surfaces of at least one first alignment hole extends exemplarily in vertical direction. Alternatively, at least one of the side surfaces of at least one first alignment hole is inclined to the vertical direction. In this case, the at least one side surface of at least one first alignment hole encloses an angle with the vertical direction of at most 80°, 60°, 40° or 30° e.g. at most 20°, 10° or 5°.

Exemplary, the power terminals can have at least one additional hole. The additional hole is exemplarily further configured to receive a screw. Exemplarily, the additional hole is configured for a screwed interconnection with an external busbar. For example, dimensions in lateral directions of the additional hole are larger than dimensions in lateral directions of the first alignment hole.

The first alignment hole has, for example, a diameter in lateral directions of at least 0.5 mm or at least 5 mm. Further, the additional hole has, for example, a diameter being bigger than the diameter of the first alignment hole.

In summary, such a power semiconductor module can provide, inter alia, the following advantages. For example, a correct alignment and positioning of the power semiconductor module in lateral directions can be realized with the help of the first alignment holes. Furthermore, when more than one power semiconductor module is to be positioned, the power semiconductor modules can be aligned and positioned correctly relative to one another with the help of the first alignment holes. Since such a power semiconductor module can be positioned properly, a cooling efficiency is not reduced and consequently a lifetime of the power semiconductor module is improved. Therefore, a reliability of the power semiconductor module is exemplary improved.

According to at least one embodiment of the power semiconductor module, the at least two protruding parts are provided on a first lateral side of the power semiconductor module or on a second lateral side of the power semiconductor module opposite the first lateral side.

According to at least one embodiment of the power semiconductor module, at least one of the at least two protruding parts are provided on a first lateral side of the power semiconductor module and at least another one of the at least two protruding parts are provided on a second lateral side of the power semiconductor module being opposite the first lateral side. This is to say that the first alignment holes are provided exemplarily on opposite lateral sides of the power semiconductor module. For example, one of the protruding parts protrudes from the housing at the first lateral side. Further, the other of the protruding parts protrudes from the housing at the second lateral side.

According to at least one embodiment of the power semiconductor module, at least one of the at least two first alignment holes has a shape being different to at least another one of the at least two first alignment holes.

Alternatively, the shapes of the at least two first alignment holes are the same.

According to at least one embodiment of the power semiconductor module, at least one of the at least two first alignment holes has a circular shape. For example, one of the first alignment holes has a cross section aligned in lateral directions being circular.

According to at least one embodiment of the power semiconductor module, at least another one of the at least two first alignment holes has a slotted hole shape. For example, one of the first alignment holes has a cross section aligned in lateral directions being shaped as a slotted hole.

For an improved handling in the alignment and positioning of the power module, for example, one of the at least two first alignment holes should be circular, e.g. round, to facilitate an exact positioning in lateral directions, whereas the other one of the at least two first alignment holes should be slotted holes being sufficient for exact rotational positioning. Exemplarily, these different shapes are also considering a possible error in the positioning due to a slightly varying distance of the first alignment holes.

Alternatively or additionally, at least one of the at least two first alignment holes can have a shape, e.g. a cross section in lateral directions, being slotted hole, elliptical, oval, triangular or squared.

A second aspect relates to a power semiconductor device. According to the embodiment of the second aspect, the power semiconductor device comprises at least one power semiconductor module described herein above. All features disclosed in connection with the power semiconductor module are therefore also disclosed in connection with the power semiconductor device and vice versa.

According to the embodiment, the power semiconductor device comprises a cooler on which the at least one power semiconductor module is arranged. The cooler exemplarily comprises a cooling cavity for receiving a cooling medium. Exemplarily the cooler comprises an inlet port and an outlet port. Exemplarily, the cooler is adapted for a flow direction of a cooling medium within the cooling cavity from the inlet port to the outlet port.

Exemplarily, the cooling medium is pumped from the inlet port through the cooling cavity to the outlet port. The cooling medium is, for example, a liquid coolant or a gas coolant. Exemplarily, heat generated during operation of the power semiconductor module can be dissipated away via the cooling medium effectively.

According to the embodiment of the power semiconductor device, the cooler is provided with at least two second alignment holes. For example, at least one of the second alignment holes completely penetrates the cooler in vertical direction.

Alternatively, at least one of the second alignment holes penetrates the cooler partially. In this case the second alignment holes extend within the cooler from a bottom surface at the first main side into the cooler.

According to the embodiment of the power semiconductor device, at least one of the at least two first alignment holes has at least one side surface extending in vertical direction or obliquely to the vertical direction.

According to the embodiment of the power semiconductor device, at least one of the at least two second alignment holes has at least one side surface extending in vertical direction or obliquely to the vertical direction.

For example, each of the second alignment holes comprises at least one side surface. At least one side surface of at least one second alignment hole extends exemplarily in vertical direction. Alternatively, at least one side surface of at least one second alignment hole is inclined to the vertical direction. In this case, the at least one side surface of at least one second alignment hole encloses an angle with the vertical direction of at most 80°, 60°, 40° or 30° e.g. at most 20°, 10° or 5°..

For example, at least one of the at least two second alignment holes can have a cross section in lateral directions being a slotted hole, circular, elliptical, oval, triangular or squared.

Exemplarily, one of the at least two second alignment holes is located in a region of a front surface of the cooler and another one of the at least two second alignment holes is located in a region of a back surface of the cooler opposite the front surface. The front surface and the back surface exemplarily extend in vertical direction. The region of the front surface extends in lateral directions in direction to the power semiconductor module and comprises, for example, the inlet port, and the region of the back surface extends in lateral directions in direction to the power semiconductor module and comprises for example the inlet port. For example, one of the at least two second alignment holes is located in a region of the inlet port and another one of the at least two second alignment holes is located in a region of the outlet port.

Due to the first alignment holes and the second alignment holes, a correct positioning and alignment of the at least one power semiconductor module to the cooler can be achieved. Simultaneously, if more than one power semiconductor modules are present, a correct positioning and alignment of the power semiconductor modules with respect to one another can be achieved.

According to at least one embodiment of the power semiconductor device, the cooling structure is formed integrally with the cooler. Exemplary, the cooling structure can comprise pin fins integrally formed with the cooler.

Alternatively, the cooling structure is, for example, a cooling region without elevated structures. In this case, the cooling structure is a cooling plate integrally formed with the cooler.

According to at least one embodiment of the power semiconductor device, the cooler is provided with at least one opening.

For example, the cooler is provided with more than one opening. Exemplarily, the openings are provided in the cooler consecutively in the direction of the flow direction. For example, the openings are spaced apart from one another in lateral directions, e.g. along the flow direction. In this case a power semiconductor module is provided on each opening.

Exemplarily, the power semiconductor module has a dimension in lateral directions being at least 5% larger than a dimension in lateral directions of the opening on which the power semiconductor module is arranged.

According to at least one embodiment of the power semiconductor device, the at least one power semiconductor module is provided on the at least one opening such that the cooling structure protrudes into a cooling cavity of the cooler.

A third aspect relates to a method for producing a power semiconductor device. For example, the method produces a power semiconductor device described herein above. Thus, all features disclosed in connection with the power semiconductor device are therefore also disclosed in connection with the method and vice versa.

According to the embodiment of the third aspect, the method comprises providing a fixture provided with at least two first alignment pins and with at least two second alignment pins. For example, the fixture comprises a base substrate on which the first alignment pins and the second alignment pins are arranged.

At least one of the first alignment pins and the second alignment pins is exemplarily formed from a rod, wherein a tip of the rod extends in vertical direction facing away from the fixture. For example, all first alignment pins and all second alignment pins have a common direction of extension being parallel to the vertical direction.

Exemplary, each of the first alignment pins is configured to be insertable into a corresponding first alignment hole. The first alignment pin has a shape adapted to the corresponding first alignment hole, for example. Exemplarily, the cross section in lateral directions of the first alignment pin is at least 10 µm, e.g. at least 500 µm or at least 1 mm, smaller than the corresponding first alignment hole.

Further, each of the second alignment pins is configured to be insertable into a corresponding second alignment hole, for example. The second alignment pin has a shape adapted to the corresponding second alignment hole, for example. Exemplarily, the cross section in lateral directions of the second alignment pin is at least 10 µm, e.g. at least 500 µm or at least 1 mm, smaller than the corresponding first alignment hole.

According to the embodiment, the method comprises providing the at least one power semiconductor device comprising at least two power terminals being provided with at least two first alignment holes.

According to the embodiment, the method comprises providing the cooler provided with at least two second alignment holes.

According to the embodiment, the method comprises arranging the cooler on the fixture such that the at least two second alignment pins are introduced into the at least two second alignment holes.

According to the embodiment, the method comprises arranging the at least one power semiconductor module on the cooler such that the at least two first alignment pins are introduced into the at least two first alignment holes.

Exemplarily, the cooler is arranged on the fixture before the at least one power semiconductor module is arranged on the cooler.

Due to the first alignment pins and holes and the second alignment pins and holes, a precise positioning of the power semiconductor module on the cooler can be achieved. The method provides a simple and easy method for correct and reproducible positioning and alignment. Further, a yield in an installation process of the power semiconductor module on one hand to a common control board or driver board, and on the other hand to a busbar structure of an inverter is increased. Consequently, this exemplarily results in an enhanced customer satisfactory. In addition, there is, for example, no cost adder when implementing alignment holes to the power terminals.

According to at least one embodiment, the method comprises, fixing the at least one power semiconductor module to the cooler by at least one clamp. For example, the clamp is configured to press the power semiconductor module in direction to the cooler. The clamp is fixed exemplarily by a clamping screw to the cooler. This is to say that the clamp presses the power semiconductor module and the cooler together in vertical direction, by tightening the clamping screw for example.

Exemplary, time needed for mounting the power semiconductor module to the cooler by screwing down clamps is reduced by the method using the first alignment pins and holes and the second alignment pins and holes and results in lower manufacturing costs. Further, by using the first alignment pins and holes and the second alignment pins and holes, exemplary, also an unwanted movement of the power semiconductor module is prevented during screwing down the clamps.

Alternatively, the at least one power semiconductor module is fixed to the cooler by gluing, sintering or soldering.

According to at least one embodiment of the method, a relative position of the at least two first alignment holes with respect to the at least two second alignment holes is preset.

According to at least one embodiment of the method, at least one of the at least two first alignment pins has at least partially at least one of the shapes cylindrical, conical.

According to at least one embodiment of the method, at least one of the at least two second alignment pins has at least partially at least one of the shapes cylindrical, conical.

For example, at least one of the first alignment pins and the second alignment pins are formed of rods having an end region being shaped cylindrically or conically.

For example, having an end region being conical, a self-alignment can be achieved.

According to at least one embodiment the method comprises, providing at least one of the at least two first alignment pins and the at least two second alignment pins with a spring element. At least one of the at least two first alignment pins are provided with a spring element, for example. Further, exemplarily at least one of the at least two second alignment pins is provided with a spring element. The spring element is exemplary configured to apply a force to a respective alignment pin in vertical direction.

According to at least one embodiment of the method, the at least one power semiconductor module further comprises at least two auxiliary terminals. For example, the auxiliary terminals are configured to provide electrical signals to the at least one power semiconductor chip. Exemplary, the auxiliary terminals are embedded in the housing, e.g. the mold compound, at least in regions. Further, each of the power terminals is embedded at least in regions within the housing, e.g. the mold compound. "Embedded" means here and the following that an outer surface of each auxiliary terminal is at least in regions close to the semiconductor chip covered by the housing, e.g. the mold compound.

According to at least one embodiment of the method, the at least two auxiliary terminals extend at least in regions in vertical direction. Due to production tolerances, the at least two auxiliary terminals extending in vertical direction in regions can enclose an angle to the vertical direction of at most 10° or at most 5°, for example, 1°.

For example, each of the auxiliary terminals has a further protruding part protruding from a lateral side from the housing. The further protruding parts of the auxiliary terminals extend in vertical direction at least in regions. End regions of the further protruding parts of the auxiliary terminals are configured to be directly contactable to a common control board or a driver board, exemplary by soldering or press fit connection.

According to at least one embodiment the method comprises, arranging a common control board comprising further second alignment holes on the fixture, wherein the further second alignment holes are configured to receive the second alignment pins.

According to at least one embodiment of the method, the common control board comprises contact holes, which are configured to receive the auxiliary terminals.

This is to say when the common control board is mounted, the further second alignment holes of the common control board are positioned in vertical direction directly above the second alignment holes of the cooler. Exemplarily, the further second alignment holes of the common control board and the second alignment holes of the cooler are overlapping congruently.

According to at least one embodiment the method comprises, arranging at least two power semiconductor modules, each being provided with at least two first alignment holes, on the cooler.

Since the method enables a correct and reproducible alignment of the power semiconductor modules on the cooler and a correct and reproducible alignment of the power semiconductor modules relative to one another, a cooling medium by-pass around the cooling structure is better controlled, for example. Furthermore, all auxiliary terminals are better aligned to one another, exemplary, for better mounting of the common control board, such as a PCB, at customer side.

The subject-matter of the disclosure will be explained in more detail in the following with reference to exemplary embodiments which are illustrated in the attached drawings.
Figure 1 schematically shows a three dimensional sketch of a power semiconductor module according to an exemplary embodiment.
Figures 2, 3, 4 and 5 each schematically show a power semiconductor device according to an exemplary embodiment.
Figures 6, 7 and 8 schematically show a method stage for producing a power semiconductor device according to an exemplary embodiment.
Figure 9 schematically shows a power semiconductor device with a common control board according to an exemplary embodiment.
Figures 10, 11, 12 and 13 each schematically show first alignment pins and or second alignment pins used by a method for producing a power semiconductor module according to an exemplary embodiment.

The reference symbols used in the drawings, and their meanings, are listed in summary form in the list of reference symbols. In principle, identical parts are provided with the same reference symbols in the figures.

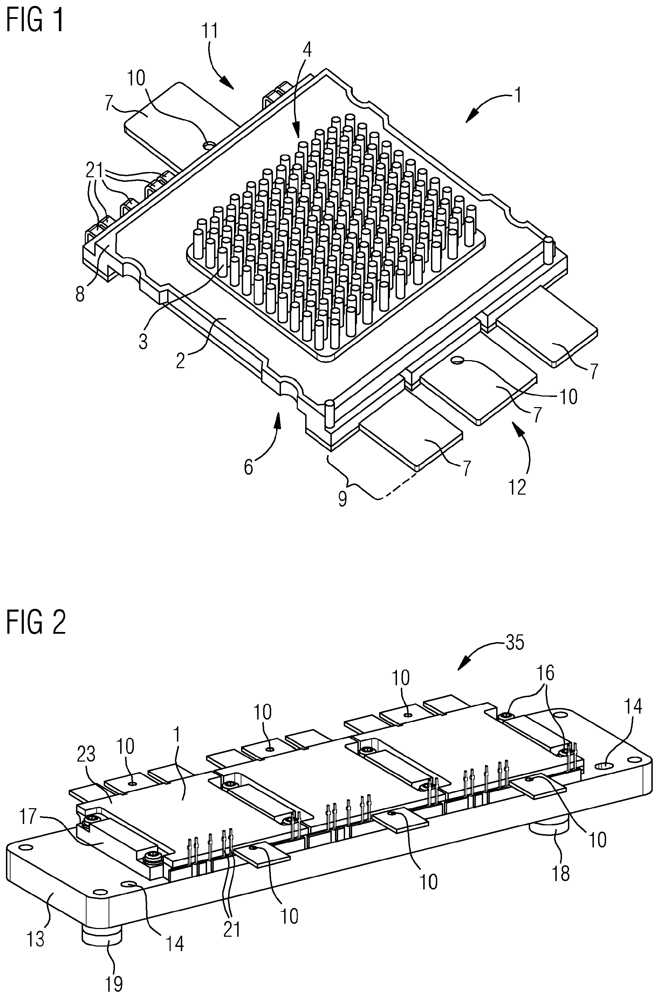

The power semiconductor module 1 according to the exemplary embodiment of Figure 1 comprises a base plate 2, alternatively a substrate, with a cooling structure 3 at a first main side. The cooling structure 3 is formed of a plurality of pin fins.

Further, at least one semiconductor chip 5 is arranged on the base plate 2 at a second main side opposite the first main side 4, not shown here since the semiconductor chip 5 is covered by a housing 23, which is in this exemplary embodiment a mold compound 8. The mold compound 8 is arranged on the power semiconductor chip 5, the at least two power terminals 7 and the base plate 2 at the second main side 6.

In addition, the power semiconductor module 1 comprises in this embodiment four power terminals 7 being in electrical contact to the at least one semiconductor chip 5. The power terminals 7 close to the power semiconductor chip 5 are embedded within the mold compound 8. Each of the power terminals 7 further extend beyond the mold compound 8 in lateral directions. Thus, each of the power terminals 7 has a protruding part 9 protruding from the mold compound 8 in lateral directions. The protruding parts 9 are free of the mold compound 8 and can be accessed freely for electrical contacting.

Two protruding parts 9, being provided on opposite lateral sides of the power semiconductor module 1, is provided with a first alignment hole 10. This is to say that one of the power terminals 7 is arranged on a first lateral side 11 being provided with one of the first alignment holes 10 and another of the power terminals 7 is arranged on a second lateral side 12 opposite the first lateral side 11 being provided with another of the first alignment holes 10.

The power semiconductor module 1 further comprises seven auxiliary terminals 21 configured to provide electrical signals to the power semiconductor chip 5. The auxiliary terminals 21 are embedded in the mold compound 8 close to the power semiconductor chip 5. The auxiliary terminals 21 extend at least in regions in vertical direction, in a region where the auxiliary terminals 21 are not embedded in the mold compound 8.

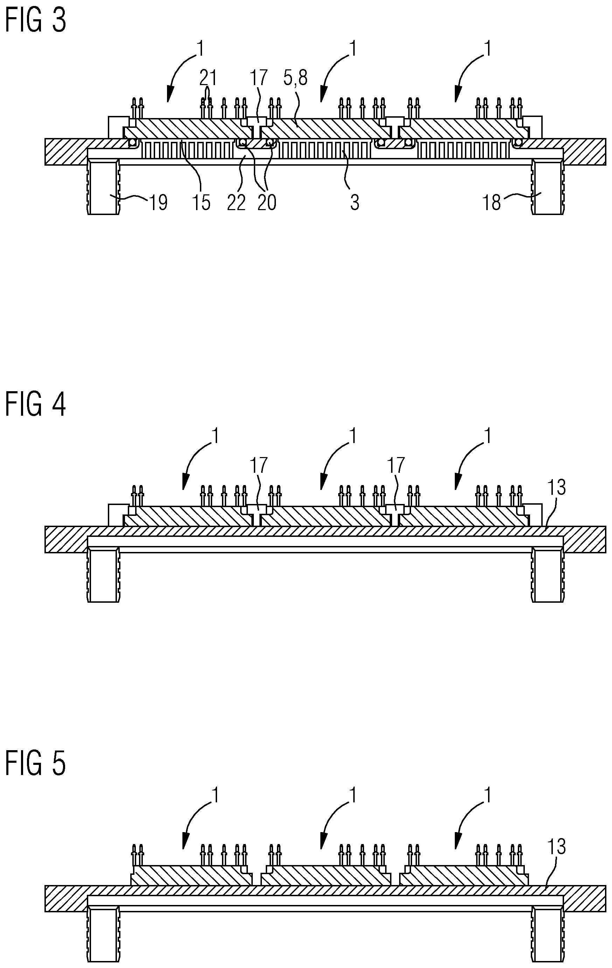

The power semiconductor device 35 according to the exemplary embodiment of Figures 2 and 3 comprises three power semiconductor modules 1 according to Figure 1 and a cooler 13. Here, Figure 3 is a cross sectional side view of the power semiconductor device 35 of Figure 2.

The cooler 13 comprises a cooling cavity 22 for receiving a cooling medium. Further, the cooler 13 comprises an inlet port 18 and an outlet port 19. Thus, the cooler 13 is adapted for a flow direction of a cooling medium within the cooling cavity 22 from the inlet port 18 to the outlet port 19.

The cooler 13 is provided with three openings 15 in this exemplary embodiment. The openings 15 are provided in the cooler 13 consecutively in the direction of the flow direction. In this exemplary embodiment, one power semiconductor module 1 is provided on each opening 15 such that each of the cooling structures 3 protrude into the cooling cavity 22 of the cooler 13.

Each of the power semiconductor modules 1 is fixed to the cooler 13 by two clamps 17. Further, each clamp 17 is fixed by two screws 16 to the cooler 13. Directly neighbouring power semiconductor modules 1 share one clamp 17. Two of the clamps 17 are configured to press one power semiconductor module 1 to the cooler 13, wherein between the cooler 13 and the power semiconductor module 1 a seal 20 is arranged. The seal 20 can comprise a flexible material being impermeable to a cooling medium.

The cooler 13 according to Figure 4 does not comprise openings 15 as shown in Figure 3. Each of the power semiconductor modules 1 is fixed directly to the cooler 13. In this exemplary embodiment, the cooling structure 3 is formed integrally with the cooler 13 in the region in vertical direction below each power semiconductor module 1.

In contrast to Figures 3 and 4, each of the power semiconductor modules 1 are fixed directly to the to the cooler 13 by gluing, sintering or soldering, without using a clamp 17, according to Figure 5.

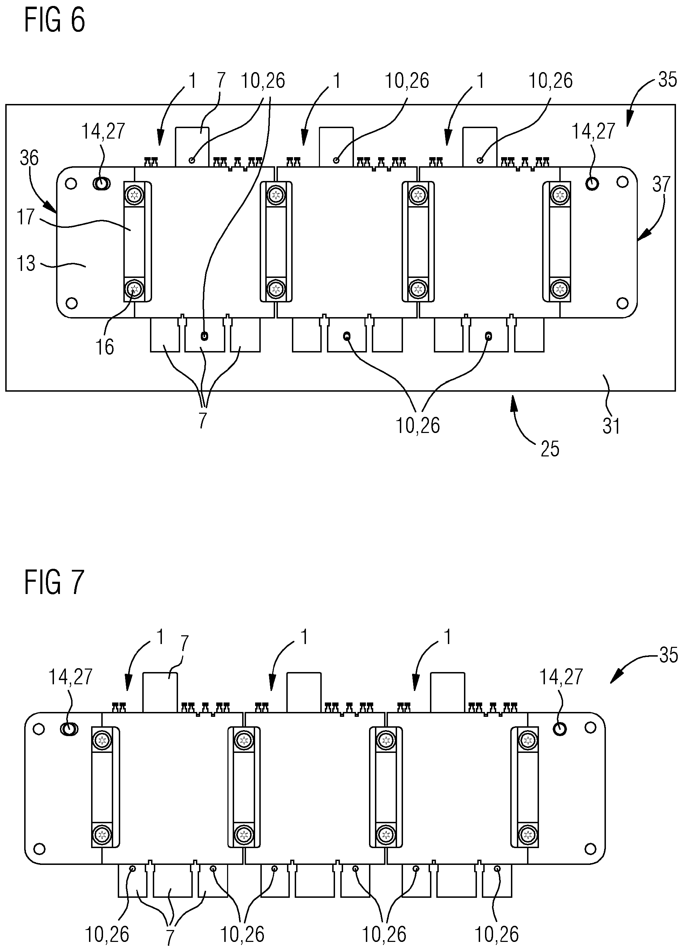

In addition, the cooler 13 is provided with two second alignment holes 14 described and shown in more detail in connection with Figures 6, 7 and 8.

In the method stage according to Figures 6, 7 and 8 a power semiconductor device 35 according to Figure 2 is produced. Initially, a fixture 25 is provided. The fixture 25 comprises a base substrate 31 on which first alignment pins 26 and second alignment pins 27 are arranged. In this embodiment, the fixture 25 comprises six first alignment pins 26 and two second alignment pins 27.

Subsequently, a cooler 13 provided with two second alignment holes 14 is arranged on the fixture 25 such that each second alignment pin 27 is introduced into one second alignment hole 14.

One of the two second alignment holes 14 is located in a region of a front surface 36 of the cooler 13 and the other one of the two second alignment holes 14 is located in a region of a back surface 37 of the cooler opposite the front surface 36

After the arrangement of the cooler 13 on the fixture 25, three power semiconductor modules 1 are arranged on the cooler 13 such that each first alignment pin 26 is introduced into one first alignment hole 10.

In connection with Figure 6, the first alignment holes 10 of each power semiconductor module 1 are arranged on opposite lateral sides of the power semiconductor module 1. E.g. one of the two first alignment holes 10 is located on a first lateral side 11 and the other of the two first alignment holes 10 is located on a second lateral side 12 opposite the first lateral side 11, as shown in connection with Figure 1. Here, the clamps 17 are connected to the cooler 13 by screws 16.

In connection with Figure 7, the protruding parts 9 with the first alignment holes 10 are provided on a same lateral side of the power semiconductor module 1.

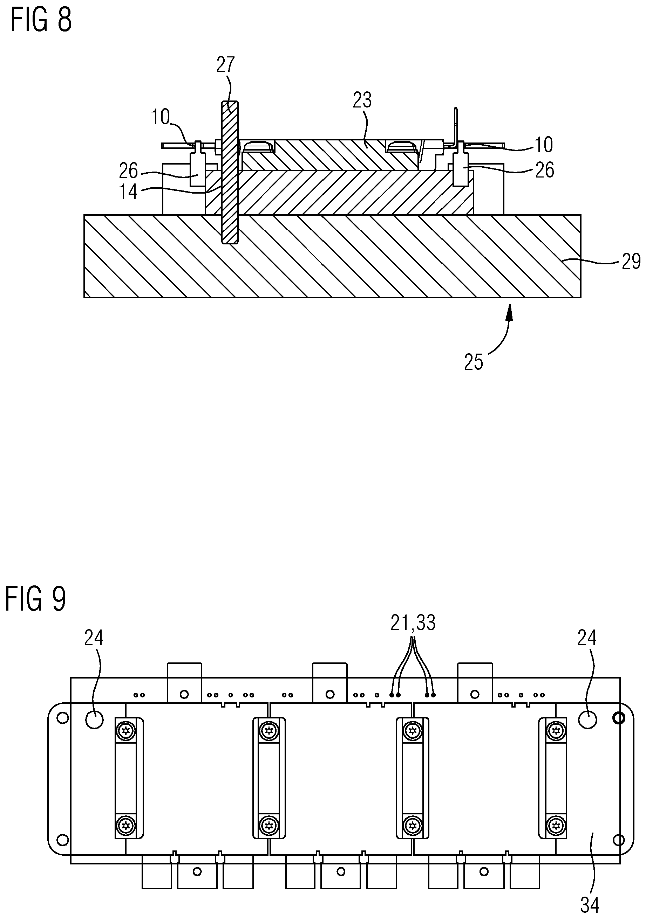

In connection with Figure 9 auxiliary terminals 21 of the power semiconductor modules 1 are aligned. The auxiliary terminals 21 can comprise pin type or press-fit type connections with which the auxiliary terminals 21 are connected to the common control board. For example, each auxiliary terminal has a pin shoulder 30 at an end region (not shown here).

A common control board 34 is arranged on the auxiliary terminals 21. The common control board 34 comprises contact holes 33 which are configured to receive the auxiliary terminals 21. Further, the common control board 34 comprises further second alignment holes 24, which are configured to receive the second alignment pins 27.

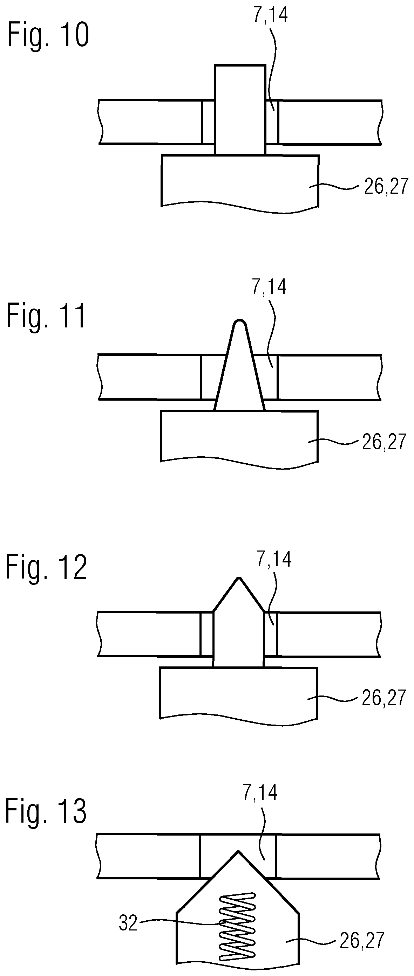

At least one of the first alignment pin 26 and second alignment pin 27 according to Figures 10, 11, 12 and 13 are formed from of a rod, differing in their end region. The end region is configured to be inserted in at least one of the first alignment hole 10 and second alignment hole 14. The end region of Figure 10 is cylindrical and the end region of Figure 11 is conical. The end region of Figure 12 is divided in two parts. The part facing the rod is formed cylindrical and the part facing away from the rod is formed conical.

At least one of the first alignment pin 26 and second alignment pin 27 according to Figure 13 is further provided with a spring element 32. For example, the spring element 32 is only used when at least one of the first alignment pin 26 and second alignment pin 27 is bigger than the corresponding alignment hole and has a conical tip, in order to reduce tolerances in lateral directions to zero. The spring element 32 is configured to apply a force in vertical direction. Exemplary, the spring element 32 is used to compensate tolerances in vertical direction.

### Reference signs list

- 1: power semiconductor module
- 2: base plate
- 3: cooling structure
- 4: first main side
- 5: semiconductor chip
- 6: second main side
- 7: power terminal
- 8: mold compound
- 9: protruding part
- 10: first alignment hole
- 11: first lateral side
- 12: second lateral side
- 13: cooler
- 14: second alignment hole
- 15: opening
- 16: screw
- 17: clamp
- 18: inlet port
- 19: outlet port
- 20: seal
- 21: auxiliary terminal
- 22: cooling cavity
- 23: housing
- 24: further second alignment holes
- 25: fixture
- 26: first alignment pin
- 27: second alignment pin
- 30: auxiliary pin shoulder
- 31: base substrate
- 32: spring element
- 33: contact holes
- 34: control board
- 35: power semiconductor device36 front surface
- 37: back surface

## Claims

1. A power semiconductor module (1), with
- at least one semiconductor chip (5) being connected to a cooling structure (3),
- at least two power terminals (7) being in electrical contact to the at least one semiconductor chip (5), and
- a housing (23) for the power semiconductor chip (5) and the at least two power terminals (7), wherein
- each of the at least two power terminals (7) has a protruding part (9) protruding beyond the housing (23) in lateral directions, and
- at least two protruding parts (9) are provided with a first alignment hole (10), and
- at least one of the at least two protruding parts (9) are provided on a first lateral side (11) of the power semiconductor module (1) and **characterized in that** at least another one of the at least two protruding parts (9) are provided on a second lateral side (12) of the power semiconductor module (1) being opposite the first lateral side (11).

2. A power semiconductor device (35), with
- at least one power semiconductor module (1) according to claim 1, and
- a cooler (13) on which the at least one power semiconductor module (1) is arranged, wherein
- the cooler (13) is provided with at least two second alignment holes (14).

3. The power semiconductor device (35) according to claim 2, wherein at least one of the at least two first alignment holes (10) has a shape being different to at least another one of the at least two first alignment holes (10).

4. The power semiconductor device (35) according to any one of the claims 2 or 3, wherein
- at least one of the at least two first alignment holes (10) has a circular shape, and
- at least another one of the at least two first alignment holes (10) has a slotted hole shape.

5. The power semiconductor device (35) according to any one of the claims 2 to 4, wherein
- the cooling structure (3) is formed integrally with the cooler (13), or
- the cooler (13) is provided with at least one opening (15), and the at least one power semiconductor module (1) is provided on one of the at least one opening (15) such that the cooling structure (3) protrudes into a cooling cavity (22) of the cooler (13).

6. The power semiconductor device (35) according to any one of the claims 2 to 5, wherein at least one of
- each of the at least one of the at least two first alignment holes (10) has at least one side surface extending in vertical direction or obliquely to the vertical direction, and
- at least one of the at least two second alignment holes (14) has at least one side surface extending in vertical direction or obliquely to the vertical direction.

7. A method for producing a power semiconductor device (35) with at least one power semiconductor module (1) and a cooler (13), comprising:
- providing a fixture (25) provided with at least two first alignment pins (26) and with at least two second alignment pins (27),
- providing the at least one power semiconductor device (35) comprising at least two power terminals (7) being provided with at least two first alignment holes (10),
- providing the cooler (13) provided with at least two second alignment holes (14),
- arranging the cooler (13) on the fixture (25) such that the at least two second alignment pins (27) are introduced in the at least two second alignment holes (14), and
- arranging the at least one power semiconductor module (1) on the cooler (13) such that the at least two first alignment pins (26) are introduced in the at least two first alignment holes (10).

8. The method according to claim 7, wherein fixing the at least one power semiconductor module (1) to the cooler (13) by at least one clamp (17).

9. The method according to any one of the claims 7 to 8, wherein a relative position of the at least two first alignment holes (10) with respect to the at least two second alignment holes (14) is pre-set.

10. The method according to any one of the claims 7 to 9, wherein at least one of the at least two first alignment pins (26) has at least partially at least one of the shapes: cylindrical, conical.

11. The method according to any one of the claims 7 to 10, wherein at least one of the at least two second alignment pins (27) has at least partially at least one of the shapes: cylindrical, conical.

12. The method according to any one of the claims 7 to 11, wherein providing at least one of the at least two first alignment pins (26) and the at least two second alignment pins (27) with a spring element (32).

13. The method according to any one of the claims 7 to 12, wherein
- the at least one power semiconductor module (1) further comprises at least two auxiliary terminals (21),
- the at least two auxiliary terminals (21) extend at least in regions in a vertical direction, and
- arranging a common control board (33) comprising further second alignment holes (24) on the fixture (25), wherein the further second alignment holes (24) are configured to receive the second alignment pins (27), such that contact holes (33) of the common control board (34) are configured to receive the auxiliary terminals (21).

14. The method according to any one of the claims 7 to 13, wherein arranging at least two power semiconductor modules (1), each being provided with at least two first alignment holes (10), on the cooler (13).

## Patentansprüche

1. Leistungshalbleitermodul (1), mit
- wenigstens einem Halbleiterchip (5), der mit einer Kühlstruktur (3) verbunden ist,
- wenigstens zwei Leistungsanschlüsse (7), die sich in elektrischem Kontakt mit dem wenigstens einen Halbleiterchip (5) befinden, und
- ein Gehäuse (23) für den Leistungshalbleiterchip (5) und die wenigstens zwei Leistungsanschlüsse (7), wobei
- jeder der wenigstens zwei Leistungsanschlüsse (7) einen hervorstehenden Teil (9) aufweist, der jenseits des Gehäuses (23) in lateralen Richtungen hervorsteht, und
- wenigstens zwei hervorstehende Teile (9) mit einem ersten Ausrichtungsloch (10) versehen sind, und
- wenigstens einer der wenigstens zwei hervorstehenden Teile (9) auf einer ersten lateralen Seite (11) des Leistungshalbleitermoduls (1) bereitgestellt ist, und **dadurch gekennzeichnet, dass** wenigstens ein anderer der wenigstens zwei hervorstehenden Teile (9) auf einer zweiten lateralen Seite (12) des Leistungshalbleitermoduls (1) bereitgestellt ist, die der ersten lateralen Seite (11) gegenüberliegt.

2. Leistungshalbleitervorrichtung (35), mit
- wenigstens einem Leistungshalbleitermodul (1) nach Anspruch 1, und
- einem Kühler (13), auf dem das wenigstens eine Leistungshalbleitermodul (1) angeordnet ist, wobei
- der Kühler (13) mit wenigstens zwei zweiten Ausrichtungslöchern (14) versehen ist.

3. Leistungshalbleitervorrichtung (35) nach Anspruch 2, wobei wenigstens eines der wenigstens zwei ersten Ausrichtungslöcher (10) eine Form aufweist, die verschieden von wenigstens einem anderen der wenigstens zwei ersten Ausrichtungslöcher (10) ist.

4. Leistungshalbleitervorrichtung (35) nach einem der Ansprüche 2 oder 3, wobei
- wenigstens eines der wenigstens zwei ersten Ausrichtungslöcher (10) eine kreisförmige Form aufweist, und
- wenigstens ein anderes der wenigstens zwei ersten Ausrichtungslöcher (10) eine schlitzförmige Lochform aufweist.

5. Leistungshalbleitervorrichtung (35) nach einem der Ansprüche 2 bis 4, wobei
- die Kühlstruktur (3) integral mit dem Kühler (13) gebildet ist, oder
- der Kühler (13) mit wenigstens einer Öffnung (15) versehen ist und das wenigstens eine Leistungshalbleitermodul (1) auf einer der wenigstens einen Öffnung (15) bereitgestellt ist, so dass die Kühlstruktur (3) in einen Kühlhohlraum (22) des Kühlers (13) hervorsteht.

6. Leistungshalbleitervorrichtung (35) nach einem der Ansprüche 2 oder 5, wobei wenigstens eines von Folgendem gilt:
- jedes des wenigstens einen der wenigstens zwei ersten Ausrichtungslöcher (10) weist wenigstens eine Seitenoberfläche auf, die sich in einer vertikalen Richtung oder schräg zu der vertikalen Richtung erstreckt, und
- wenigstens eines der wenigstens zwei zweiten Ausrichtungslöcher (14) weist wenigstens eine Seitenoberfläche auf, die sich in einer vertikalen Richtung oder schräg zu der vertikalen Richtung erstreckt.

7. Verfahren zum Produzieren einer Leistungshalbleitervorrichtung (35) mit wenigstens einem Leistungshalbleitermodul (1) und einem Kühler (13), welches Folgendes umfasst:
- Bereitstellen einer Halterung (25), die mit wenigstens zwei ersten Ausrichtungsstiften (26) und mit wenigstens zwei zweiten Ausrichtungsstiften (27) versehen ist,
- Bereitstellen der wenigstens einen Leistungshalbleitervorrichtung (35), die wenigstens zwei Leistungsanschlüsse (7) umfasst, die mit wenigstens zwei ersten Ausrichtungslöchern (10) versehen sind,
- Bereitstellen des Kühlers (13), der mit wenigstens zwei zweiten Ausrichtungslöchern (14) versehen ist,
- Anordnen des Kühlers (13) auf der Halterung (25), so dass die wenigstens zwei zweiten Ausrichtungsstifte (27) in die wenigstens zwei zweiten Ausrichtungslöcher (14) eingeführt werden, und
- Anordnen des wenigstens einen Leistungshalbleitermoduls (1) auf dem Kühler (13), so dass die wenigstens zwei ersten Ausrichtungsstifte (26) in die wenigstens zwei ersten Ausrichtungslöcher (10) eingeführt werden.

8. Verfahren nach Anspruch 7, wobei das wenigstens eine Leistungshalbleitermodul (1) durch wenigstens eine Klammer (17) an dem Kühler (13) befestigt wird.

9. Verfahren nach einem der Ansprüche 7 bis 8, wobei eine relative Position der wenigstens zwei ersten Ausrichtungslöcher (10) mit Bezug auf die wenigstens zwei zweiten Ausrichtungslöcher (14) vorausbestimmt ist.

10. Verfahren nach einem der Ansprüche 7 bis 9, wobei wenigstens einer der wenigstens zwei ersten Ausrichtungsstifte (26) wenigstens teilweise wenigstens eine der folgenden Formen aufweist: zylindrisch, kegelförmig.

11. Verfahren nach einem der Ansprüche 7 bis 10, wobei wenigstens einer der wenigstens zwei zweiten Ausrichtungsstifte (27) wenigstens teilweise wenigstens eine der folgenden Formen aufweist: zylindrisch, kegelförmig.

12. Verfahren nach einem der Ansprüche 7 bis 11, wobei wenigstens einer der wenigstens zwei ersten Ausrichtungsstifte (26) und der wenigstens zwei zweiten Ausrichtungsstifte (27) mit einem Federelement (32) versehen wird.

13. Verfahren nach einem der Ansprüche 7 bis 12, wobei
- das wenigstens eine Leistungshalbleitermodul (1) ferner wenigstens zwei Hilfsanschlüsse (21) umfasst,
- sich die wenigstens zwei Hilfsanschlüsse (21) wenigstens in Gebiete in einer vertikalen Richtung erstrecken, und
- eine gemeinsame Steuerplatine (33), die weitere zweite Ausrichtungslöcher (24) umfasst, auf der Halterung (25) angeordnet wird, wobei die weiteren zweiten Ausrichtungslöcher (24) zum Empfangen der zweiten Ausrichtungsstifte (27) konfiguriert sind, so dass Kontaktlöcher (33) der gemeinsamen Steuerplatine (34) zum Empfangen der Hilfsanschlüsse (21) konfiguriert sind

14. Verfahren nach einem der Ansprüche 7 bis 13, wobei wenigstens zwei Leistungshalbleitermodule (1), die jeweils mit wenigstens zwei ersten Ausrichtungslöchern (10) versehen sind, auf dem Kühler (13) angeordnet werden.

## Revendications

1. Module à semi-conducteur de puissance (1), comportant :
- au moins une puce à semi-conducteur (5) connectée à une structure de refroidissement (3),
- au moins deux bornes de puissance (7) en contact électrique avec l'au moins une puce à semi-conducteur (5), et
- un boîtier (23) pour la puce à semi-conducteur de puissance (5) et les au moins deux bornes de puissance (7), dans lequel
- chacune des au moins deux bornes de puissance (7) présente une partie saillante (9) faisant saillie au-delà du boîtier (23) dans des directions latérales, et
- au moins deux parties saillantes (9) sont pourvues d'un premier trou d'alignement (10), et
- au moins une des au moins deux parties saillantes (9) est située sur un premier côté latéral (11) du module à semi-conducteur de puissance (1), et **caractérisé en ce qu'**au moins une autre des au moins deux parties saillantes (9) est située sur un deuxième côté latéral (12) du module à semi-conducteur de puissance (1) opposé au premier côté latéral (11).

2. Dispositif à semi-conducteur de puissance (35), comportant
- au moins un module à semi-conducteur de puissance (1) selon la revendication 1, et
- un refroidisseur (13) sur lequel est agencé l'au moins un module à semi-conducteur de puissance (1), dans lequel
- le refroidisseur (13) est pourvu d'au moins deux deuxièmes trous d'alignement (14).

3. Dispositif à semi-conducteur de puissance (35) selon la revendication 2, dans lequel au moins un des au moins deux premiers trous d'alignement (10) présente une forme qui est différente de celle d'au moins un autre des au moins deux premiers trous d'alignement (10).

4. Dispositif à semiconducteur de puissance (35) selon l'une quelconque des revendications 2 ou 3, dans lequel
- au moins un des au moins deux premiers trous d'alignement (10) présente une forme circulaire, et
- au moins un autre des au moins deux premiers trous d'alignement (10) présente une forme de trou fendu.

5. Dispositif à semiconducteur de puissance (35) selon l'une quelconque des revendications 2 à 4, dans lequel
- la structure de refroidissement (3) est formée d'un seul tenant avec le refroidisseur (13), ou
- le refroidisseur (13) est pourvu d'au moins une ouverture (15), et l'au moins un module à semi-conducteur de puissance (1) est situé sur l'une de l'au moins une ouverture (15), de sorte que la structure de refroidissement (3) fait saillie dans une cavité de refroidissement (22) du refroidisseur (13).

6. Dispositif à semi-conducteur de puissance (35) selon l'une quelconque des revendications 2 à 5, dans lequel
- chacun de l'au moins un des au moins deux premiers trous d'alignement (10) présente au moins une surface latérale s'étendant dans la direction verticale ou obliquement par rapport à la direction verticale, et
- au moins un des au moins deux deuxièmes trous d'alignement (14) présente au moins une surface latérale s'étendant dans la direction verticale ou obliquement par rapport à la direction verticale.

7. Procédé de fabrication d'un dispositif à semi-conducteur de puissance (35) comportant au moins un module à semi-conducteur de puissance (1) et un refroidisseur (13), comprenant :
- la fourniture d'un support (25) pourvu d'au moins deux premières broches d'alignement (26) et d'au moins deux deuxièmes broches d'alignement (27),
- la fourniture de l'au moins un dispositif à semi-conducteur de puissance (35) comprenant au moins deux bornes de puissance (7) pourvues d'au moins deux premiers trous d'alignement (10),
- la fourniture du refroidisseur (13) pourvu d'au moins deux deuxièmes trous d'alignement (14).
- l'agencement du refroidisseur (13) sur le support (25) de telle sorte que les au moins deux deuxièmes broches d'alignement (27) s'introduisent dans les au moins deux deuxièmes trous d'alignement (14), et
- l'agencement de l'au moins un module à semi-conducteur de puissance (1) sur le refroidisseur (13) de telle sorte que les au moins deux premières broches d'alignement (26) s'introduisent dans les au moins deux premiers trous d'alignement (10).

8. Procédé selon la revendication 7, dans lequel l'au moins un module à semi-conducteur de puissance (1) est fixé au refroidisseur (13) au moyen d'au moins une bride de serrage (17).

9. Procédé selon l'une quelconque des revendications 7 à 8, dans lequel une position relative des au moins deux premiers trous d'alignement (10) par rapport aux au moins deux deuxièmes trous d'alignement (14) est prédéfinie.

10. Procédé selon l'une quelconque des revendications 7 à 9, dans lequel au moins une des au moins deux premières broches d'alignement (26) présente au moins en partie au moins une des formes suivantes : cylindrique, conique.

11. Procédé selon l'une quelconque des revendications 7 à 10, dans lequel au moins une des au moins deux deuxièmes broches d'alignement (27) présente au moins en partie au moins une des formes suivantes : cylindrique, conique.

12. Procédé selon l'une quelconque des revendications 7 à 11, dans lequel un élément à ressort (32) est incorporé dans au moins une des au moins deux premières broches d'alignement (26) et des au moins deux deuxièmes broches d'alignement (27).

13. Procédé selon l'une quelconque des revendications 7 à 12, dans lequel
- l'au moins un module à semi-conducteur de puissance (1) comprend en outre au moins deux bornes auxiliaires (21),
- les au moins deux bornes auxiliaires (21) s'étendent au moins dans des zones dans une direction verticale, et
- une carte de commande commune (33) comprenant des deuxièmes trous d'alignement supplémentaires (24) est agencée sur le support (25), les deuxièmes trous d'alignement supplémentaires (24) étant configurés pour recevoir les deuxièmes broches d'alignement (27), de telle sorte que des trous de contact (33) de la carte de commande commune (34) sont configurés pour recevoir les bornes auxiliaires (21).

14. Procédé selon l'une quelconque des revendications 7 à 13, dans lequel au moins deux modules à semi-conducteur de puissance (1) sont agencés, chacun étant pourvu d'au moins deux premiers trous d'alignement (10), sur le refroidisseur (13).
